# EUROPEAN PATENT APPLICATION

(11) **EP 4 083 929 A1**
(43) Date of publication of application: **02.11.2022**
(21) Application number: 20908125.6
(22) Date of filing: 04.12.2020
(51) Int. Cl.: G06T 19/00, G06Q 50/10

(54) **INFORMATION PROVIDING DEVICE, INFORMATION PROVIDING SYSTEM, INFORMATION PROVIDING METHOD, AND INFORMATION PROVIDING PROGRAM**

(30) Priority: 24.12.2019 JP 2019233397
(71) Applicant: Vega Corporation Co., Ltd., Fukuoka-shi, Fukuoka 812-0038 (JP)
(72) Inventor: UKISHIRO, Tomokazu, Fukuoka-shi, Fukuoka 812-0038 (JP); MIYASUE, Keigo, Fukuoka-shi, Fukuoka 812-0038 (JP)
(74) Representative: AWA Sweden AB
(86) International application number: PCT/JP2020/045341
(87) International publication number: WO 2021/131622

(57) **Abstract**

An information providing apparatus 100 of an information providing system 1 includes, as functions thereof: an attribute information acquisition unit 131 that receives user attribute information; a layout information reception unit 132 that receives layout information for a user's room; a preference information acquisition unit 133 that receives preference information indicating a user's preference for the room; a three-dimensional space generation unit 134 that generates a three-dimensional space simulating the user's room based on the layout information for the user's room; a furniture arrangement unit 135 that selects furniture information pertaining to furniture suitable for the user based on the attribute information, the layout information, or the preference information, and arranges the furniture information in the three-dimensional space; and a three-dimensional space presentation unit 136 that presents the user with the three-dimensional space with the furniture arranged.

## Description

### FIELD

The present disclosure relates to an information providing apparatus, an information providing system, an information providing method, and an information providing program that present a three-dimensional space in which candidate furniture for purchase is arranged.

### BACKGROUND

In recent years, mail order sales, in which products are sold via media such as the Internet, have become popular. Mail order sales are useful particularly for large or heavy merchandise that requires time and effort to be carried into a home after purchase at a store, because it is possible to have the merchandise carried into the home by a dedicated delivery company.

An example of such large merchandise is furniture. A number of vendors use mail order sales for furniture as well. In particular, vendors who sell furniture via the Internet post image information such as pictures of the furniture on the Internet to compensate for a weakness of mail order sales, the inability to see and purchase an actual piece of merchandise.

However, since furniture is to be placed and used in a residence, it is important that it is compatible in function and design with the residence in which it is currently residing or will reside, as well as with other furniture. For this reason, a prospective buyer who sees the image information for the furniture itself does not receive a clear image, and it has often been difficult to make a decision on a purchase. Therefore, in mail order sales of furniture, it is important to be able to provide an image of how the furniture will look when it is actually placed in a residence.

For example, Patent Literature 1 discloses an interior view image creation apparatus that creates an image of an interior space of a building from a three-dimensional model of the building. The interior view image creation apparatus described in Patent Literature 1 is configured to create an interior view image of a space from a predetermined viewpoint on the basis of a planar shape of the space, openings in the space, fittings, fixtures or furniture arranged in the space.

### CITATION LIST

### PATENT LITERATURE

[Patent Literature 1]
Jpn. Pat. Appln. KOKAI Publication No. 2017-174310

### SUMMARY

### TECHNICAL PROBLEM

However, since the interior view image creation apparatus described in Patent Literature 1 does not display image information for furniture actually on sale via mail order in the interior view image, it is not possible to create an image of the combination of the furniture with the residence you are currently living in or are planning to live in.

Accordingly, the present disclosure describes an information providing apparatus, an information providing system, an information providing method, and an information providing program that are capable of presenting a three-dimensional space representing an actual residence having candidate furniture for purchase arranged therein.

### SOLUTION TO PROBLEM

An information providing apparatus in one aspect of the present disclosure includes: a user information acquisition unit that acquires information on a user; a layout information reception unit that receives an input of layout information for a room from a user; a three-dimensional space generation unit that generates a 3D-modeled three-dimensional space based on the received layout information; a furniture arrangement unit that selects, from furniture information stored in advance, furniture information suitable for the user based on the user information and the layout information, and arranges furniture pertaining to the selected furniture information in the three-dimensional space; and a three-dimensional space presentation unit that presents the three-dimensional space in which the furniture is arranged to the user.

An information providing system in one aspect of the present disclosure is an information providing system that includes an information providing apparatus and a user terminal, the information providing apparatus including: a user information acquisition unit that acquires information on a user; a layout information reception unit that receives layout information for a room from the user terminal; a three-dimensional space generation unit that generates a 3D-modeled three-dimensional space based on the received layout information; a furniture arrangement unit that selects, from furniture information stored in advance, furniture information suitable for the user based on the user information and the layout information, and arranges furniture pertaining to the selected furniture information in the three-dimensional space; and a three-dimensional space presentation unit that transmits the three-dimensional space in which the furniture is arranged to the user terminal, and the user terminal including: a layout information transmission unit that receives an input of layout information for a room from a user and transmits the input to the information providing apparatus; and a three-dimensional space display unit that receives the three-dimensional space in which the furniture is arranged from the information providing apparatus and displays the three-dimensional space in which the furniture is arranged for the user.

An information providing method in one aspect of the present disclosure includes: a user information acquisition step of a user information acquisition unit acquiring information on a user; a layout information reception step of a layout information reception unit receiving an input of layout information for a room from a user; a three-dimensional space generation step of a three-dimensional space generation unit generating a 3D-modeled three-dimensional space based on the received layout information; a furniture arrangement step of a furniture arrangement unit selecting, from furniture information stored in advance, furniture information suitable for the user based on the user information and the layout information and arranging furniture pertaining to the selected furniture information in the three-dimensional space; and a three-dimensional space presentation step of a three-dimensional space presentation unit presenting the three-dimensional space in which the furniture is arranged to the user.

An information providing program in one aspect of the present disclosure causes an electronic computer to execute: a user information acquisition step of acquiring information on a user; a layout information reception step of receiving an input of layout information for a room from a user;
a three-dimensional space generation step of generating a 3D-modeled three-dimensional space based on the received layout information; a furniture arrangement step of selecting, from furniture information stored in advance, furniture information suitable for the user based on the user information and the layout information and arranging furniture pertaining to the selected furniture information in the three-dimensional space; and a three-dimensional space presentation step of presenting the three-dimensional space in which the furniture is arranged to the user.

### ADVANTAGEOUS EFFECT OF INVENTION

According to the present disclosure, an input of layout information for a room is received from a user, a three-dimensional space based on the layout information is generated, furniture information suitable for the user is selected, and the furniture is arranged in the three-dimensional space and then presented to the user. Accordingly, it is possible to present the state in which furniture pertaining to the furniture information is arranged in the layout information of an actual residence received from the user. It is thus possible for the user to visually grasp an image of candidate furniture for purchase arranged in the actual residence through the three-dimensional space.

### BRIEF DESCRIPTION OF THE DRAWINGS

FIG. 1 is a functional configuration block diagram showing an information providing system 1 according to an embodiment of the present disclosure.
FIG. 2 is a functional configuration block diagram showing a user terminal 200 shown in FIG. 1.
FIG. 3 is a flowchart showing an operation of the information providing system 1 shown in FIG. 1.
FIG. 4 is a schematic diagram showing an example of capturing layout information to be displayed on the display unit 220 shown in FIG. 2.
FIG. 5 is a schematic diagram showing an example of inputting preference information to be displayed on the display unit 220 shown in FIG. 2.
FIG. 6 is a schematic diagram showing an example three-dimensional space R generated by the three-dimensional space generation unit 134 shown in FIG. 1.
FIG. 7 is a schematic diagram showing example data held in the furniture DB 123 shown in FIG. 1.
FIG. 8 is a schematic diagram showing an example display of a three-dimensional space displayed on the display unit 220 shown in FIG. 2.
FIG. 9 is a schematic diagram showing an example presentation of furniture information displayed on the display unit 220 shown in FIG. 2.
FIG. 10 is a functional configuration block diagram showing an information providing system 1A according to an embodiment of the present disclosure.
FIG. 11 is a functional configuration block diagram showing an information providing system 1B according to an embodiment of the present disclosure.
FIG. 12 is a functional configuration block diagram showing a computer 700 according to an embodiment of the present disclosure.

### DETAILED DESCRIPTION

Hereinafter, embodiments of the present disclosure will be described in detail with reference to the drawings. Note that the embodiments described below do not unduly limit the present disclosure as recited in the claims. Also, not all of the components shown in the embodiments may be essential components for the present disclosure.

### <Configuration>

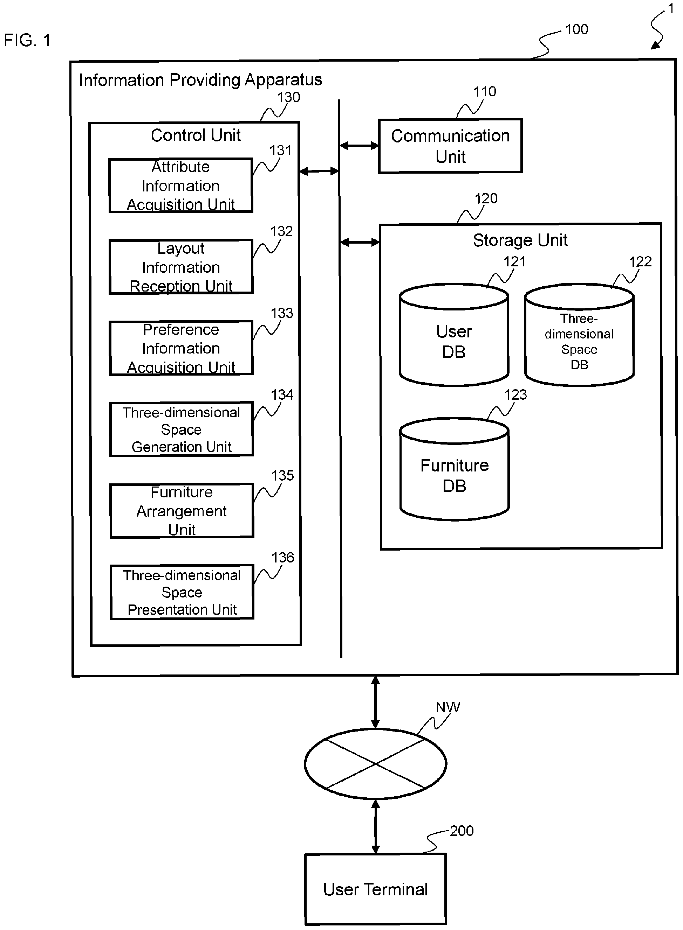

FIG. 1 is a configuration block diagram showing an information providing system 1 according to an embodiment of the present disclosure. The information providing system 1 is, but is not limited to, for example a system operated by a vendor who sells furniture which provides information on furniture that is merchandise and which presents furniture for sale that is arranged in a three-dimensional space based on layout information for a room of a user who is a customer of the vendor. The presentation of the three-dimensional space by the information providing system 1 is provided through, for example, an omnidirectional image, a whole-sky sphere image, or application of virtual reality (VR) technology, and the user uses a user terminal to grasp the three-dimensional space having the furniture arranged therein.

The furniture to be arranged in the three-dimensional space by the information providing system 1 is selected based on user attribute information and preference information. The information providing system 1 thus receives inputs of the user attribute information and the preference information.

The information providing system 1 includes an information providing apparatus 100, a user terminal 200, and a network NW. The information providing apparatus 100 and the user terminal 200 are mutually connected via the network NW. The network NW is a network for communication, and is, but is not limited to, for example a communication network including the Internet, an intranet, a local area network (LAN), a wide area network (WAN), a wireless LAN (WLAN), a wireless WAN (WWAN), a virtual private network (VPN), or the like.

The information providing apparatus 100 receives inputs of the user attribute information, the room layout information, and the user's preference information from a user, generates a three-dimensional space based on the layout information, selects furniture information suitable for the user on the basis of the user attribute information and the preference information to arrange this furniture in the three-dimensional space, and then presents the furniture arranged in the three-dimensional space to the user. The information providing apparatus 100 is, but is not limited to, for example an apparatus including a computer (such as a desktop, a laptop, or a tablet) that provides various web services, a server apparatus, or the like. Note that the server apparatus is not limited to a server apparatus that operates on its own, but may be a distributed server system that operates cooperatively through communication via the network NW, or a cloud server.

The user terminal 200 is a terminal device for the user to input the user attribute information, the room layout information, and the user's preference information to the information providing apparatus 100 and to receive the presentation of the three-dimensional space in which the furniture is arranged; and the user terminal 200 includes, but is not limited to, for example a smartphone, a portable terminal, a computer (such as a desktop, a laptop, or a tablet), or the like. The user terminal 200 has an application for obtaining a service of the information providing system 1 that is installed or a URL or the like for accessing the information providing apparatus 100 that is set, and the service is started by, for example, tapping or double-clicking the application or the URL. The user terminal 200 is also provided with a camera function for photographing or filming a user's room.

The information providing apparatus 100 includes a communication unit 110, a storage unit 120, and a control unit 130.

The communication unit 110 is a communication interface for wired or wireless communication with the user terminal 200 via the network NW, and may apply any communication protocol as long as they can mutually communicate. The communication protocol for the communication unit 110 to perform communication is, but is not limited to, for example Transmission Control Protocol/Internet Protocol (TCP/IP).

The storage unit 120 stores a program, input data, or the like for executing various control processes or each function of the control unit 130, and the storage unit 120 includes, but is not limited to, for example a memory such as RAM (Random Access Memory) and ROM (Read Only Memory), or a storage such as an HDD (Hard Disk Drive), SSD (Solid State Drive), and flash memory. The storage unit 120 also stores a user database (DB) 121, a three-dimensional space DB 122, and a furniture DB 123. Further, the storage unit 120 temporarily stores data when communicating with the user terminal 200 or data generated in each process described below.

The user DB 121 holds identification data for identifying a user who intends to purchase furniture from a vendor operating the information providing system 1, or attribute information such as the age, sex, and place of residence of the user. The identification data of the user is information for logging into the information providing system 1; and the identification data may be issued on the information providing system 1, may be determined based on an input from the user, or may be the user's e-mail address or the like.

The user DB 121 further holds preference information for a user who intends to purchase furniture. The preference information is information on the user's preferences for a living room and furniture of a house. More specifically, the preference information is information on a design, taste, and/or color of the living room and furniture of the house, information indicating a room atmosphere due to these design, taste, and/or color, or information indicating a functionality of the furniture to be used; examples of the information include "Asian", "European", "Japanese", "vintage", "dark", "ivory", "natural", and "low to the ground". The preference information is received by a preference information acquisition unit 133, described below, to hold one or more sets of tag information containing words and phrases such as the aforementioned examples.

The three-dimensional space DB 122 holds information on a three-dimensional space simulating a user's room, which is generated from the layout information for the user's room. More specifically, the information on the three-dimensional space is information on constituents of a space generated by information on the layout of the user's room, dimensions of the interior of the room, a pattern of a floor or wall, a door or window, and the presence or absence of a storage space, which is information generated from room image information captured by the user with a camera function of the user terminal 200, as described below. This information on the three-dimensional space is three-dimensional (3D)-modeled information.

The furniture DB 123 holds information on furniture sold by a vendor operating the information providing system 1. The furniture information is more specifically information on a type of the furniture such as "sofa" and "table", or a design, taste, or color of the furniture such as "vintage", "dark", "ivory", and "natural", or information indicating dimensions and a price of the furniture.

The furniture DB 123 also holds image information for the furniture for a furniture arrangement unit 135, as described below, to arrange the furniture in the three-dimensional space. The three-dimensional space is three-dimensional (3D)-modeled information, and the image information for the furniture to arrange in the three-dimensional space is also three-dimensional (3D)-modeled information.

The control unit 130 executes a program stored in the storage unit 120, thereby controlling the overall operation of the information providing apparatus 100 and is, but is not limited to, for example an apparatus including a central processing unit (CPU), a micro-processing unit (MPU), a graphics processing unit (GPU), a microprocessor, a processor core, a multiprocessor, an application-specific integrated circuit (ASIC), and a field-programmable gate array (FPGA). As functions of the control unit 130, the control unit 130 includes an attribute information acquisition unit (user information acquisition unit) 131, a layout information reception unit 132, a preference information acquisition unit (user information acquisition unit) 133, a three-dimensional space generation unit 134, a furniture arrangement unit 135, and a three-dimensional space presentation unit 136. The attribute information acquisition unit 131, the layout information reception unit 132, the preference information acquisition unit 133, the three-dimensional space generation unit 134, the furniture arrangement unit 135, and the three-dimensional space presentation unit 136 are activated by a program stored in the storage unit 120 and executed by the information providing apparatus 100.

The attribute information acquisition unit 131 receives, via the communication unit 110, attribute information for a user accessing the information providing device 100 from the user terminal 200. The user attribute information includes, but is not limited to, information on the age, sex, and place of residence of the user, information on furniture browsed on the information providing apparatus 100, or information on furniture purchased from a vendor operating the information providing system 1. The attribute information is received at the time of inputting information such as the user's address, name, contact information, and means of payment, which is input when the user registers for membership in the information providing system 1 or purchases furniture from the vendor. The received user attribute information is held in the user DB 121. Note that the attribute information acquisition unit 131 may automatically acquire the user attribute information from another web service or the like.

The layout information reception unit 132 receives the layout information for the user's room from the user terminal 200 via the communication unit 110. The layout information for the room includes, but is not limited to, for example image information in the form of a still image or video information in the form of a moving image of the user's room captured by the user terminal 200 through a user's operation; however, the layout information for the room may also be layout information input from the user terminal 200 through the user's operation, information on dimensions of the interior of the room, or information on a layout diagram provided by a real estate agent or the like. The present embodiment is described with room image information captured by a user taken as an example. The room referred to here is not limited to a room in which the user actually resides and may be a room which the user is about to move into (e.g., image information or video information captured during a preview of a real estate property).

An example of acquisition of the image information for the user's room by the user photographing or filming will be described below. The user operates the user terminal 200 to perform photographing or filming in a direction toward a wall of the room and starts photographing or filming with a predetermined position, e.g., a corner position, in the horizontal direction of the room set as a start position. In that state, the user terminal 200 is turned either left or right to rotate and photographing or filming is maintained almost in an entire circle in the room to acquire image information for all directions toward the wall of the room. At this time, the photographing or filming in the direction toward the room wall by the user terminal 200 may be video filming or continuous shooting of still images; desirably, the photographing or filming is performed with the wall, ceiling, and floor of the room included as a subject. The image information or the video information captured by the user terminal 200 is transmitted to the information providing apparatus 100, and is acquired by the layout information reception unit 132 via the communication unit 110. The layout information reception unit 132 sets, for example, a predetermined position such as a corner position of the room as a feature point, and acquires information on a coordinate displacement from that position as the layout information. The acquired image information for the user's room is temporarily stored in the storage unit 120.

The preference information acquisition unit 133 receives, via the communication unit 110, preference information indicating a user's preference for a room from the user terminal 200. The preference information acquisition unit 133 transmits, to the user terminal 200, a question about the aforementioned information on the design, taste, or color of the living room or furniture of the house, and the room atmosphere due to these factors in order to acquire these sets of information as the user's preference information, and receives an answer to the question to receive it as the preference information. The received preference information is held in the user DB 121. Note that the preference information acquisition unit 133 may automatically acquire the user's preference information from another web service or the like.

The three-dimensional space generation unit 134 generates a three-dimensional space simulating a user's room based on the layout information for the user's room received by the layout information reception unit 132. More specifically, the three-dimensional space generation unit 134 analyzes the image information or the video information captured by the user terminal 200, extracts information on the layout of the user's room and dimensions of the interior of the room, and generates a three-dimensional space that is three-dimensional (3D)-modeled so as to simulate the user's room. The three-dimensional space generation unit 134 may also extract information such as a pattern on a floor or wall, a door or window, and the presence or absence of a storage space to generate, on the basis of this information, the three-dimensional space that is three-dimensional (3D)-modeled so as to simulate the user's room. Further, the three-dimensional space generation unit 134 may analyze the captured image information or video information to extract information on the use (e.g., a studio apartment for living alone, a living room of a residence having multiple rooms, etc.) or taste (e.g., vintage, dark, etc.) of the user's room. This three-dimensional space is represented, for example, by an omnidirectional image or a whole-sky sphere image. At this time, the three-dimensional space generation unit 134 analyzes the image information or the video information and calculates dimensions of the interior of the room based on the distance from the wall of the room that is the subject. Information on the generated three-dimensional space is held in the three-dimensional space DB 122. Note that the three-dimensional space generation unit 134 may perform a coordinate transformation to project the generated three-dimensional space onto a two-dimensional plane, for example, in order to display the generated three-dimensional space on a screen of the user terminal 200.

Based on the attribute information received by the attribute information acquisition unit 131, the layout information received by the layout information reception unit 132, or the preference information received by the preference information acquisition unit 133, the furniture arrangement unit 135 selects furniture information pertaining to furniture suitable for the user from the furniture information held in the furniture DB 123. Note that the furniture selected by the furniture arrangement unit 135 may be one or more pieces of furniture and may be presented and determined by the user's selection. At this time, a plurality pieces of furniture of a similar type may be presented, or a set of pieces of furniture may be presented. Further, the furniture arrangement unit 135 arranges the three-dimensional (3D)-modeled image information for the furniture on the three-dimensional (3D)-modeled three-dimensional space generated by the three-dimensional space generation unit 134. At this time, the furniture arrangement unit 135 selects furniture information from the furniture information held in the furniture DB 123 based on the dimensions of the furniture, article information indicating the type of the furniture, shape information indicating its appearance, color information, or price information, and arranges the furniture information in the three-dimensional space. Note that the furniture arrangement unit 135 may arrange the image information for the furniture in the three-dimensional space according to a predetermined rule. This rule can be defined, for example, as:
"Do not arrange furniture in front of a door"; or
"Arrange furniture so as not to block a window (furniture with a height such that it does not block a window may be arranged)."

The furniture arrangement unit 135 determines furniture that is close to the user's preference, as an example rather than a limitation, based on the attribute information received by the attribute information acquisition unit 131 in view of purchase information (not shown) on purchasing history of the user or another user having the attribute from the vendor operating the information providing system 1, and selects the determined furniture as furniture information pertaining to furniture suitable for the user. For example, based on the attribute information, users may be classified into segments such as a woman in her twenties residing in prefecture X and a man in his forties residing in prefecture Y, and suitable furniture information may be selected from the furniture DB 123 based on the furniture information for the type, shape, and price range of the furniture that is close to the user's preference in view of purchasing behavior characteristics seen for each segment.

In addition, as an example rather than a limitation, the furniture arrangement unit 135 determines atmosphere information indicating an atmosphere of the room from the layout information received by the layout information reception unit 132, and selects furniture fitting into the atmosphere information as the furniture information pertaining to the furniture suitable for the user. For example, based on the analysis results of the image information or the video information for the layout information, the atmosphere of the room may be classified into atmosphere information such as "Asian" and "European style", and furniture information of the atmosphere concerned may be selected from the furniture DB 123 as furniture information close to the user's preference.

In addition, as an example rather than a limitation, the furniture arrangement unit 135 determines the user's preference information from the preference information received by the preference information acquisition unit 133, and selects furniture fitting into the preference information as the furniture information pertaining to the furniture suitable for the user. For example, from the answer to the question by the preference information acquisition unit 133, the user's preference information may be classified into preference information such as "vintage", "dark", and "ivory", and furniture information concerned may be selected from the furniture DB 123 as the furniture information close to the user's preference.

The three-dimensional space presentation unit 136 transmits the three-dimensional space in which the furniture is arranged by the furniture arrangement unit 135 to the user terminal 200 via the communication unit 110, and presents the three-dimensional space to the user. At this time, the three-dimensional space presentation unit 136 presents the three-dimensional (3D)-modeled three-dimensional space, which is generated by the three-dimensional space generation unit 134 and in which the furniture is arranged by the furniture arrangement unit 135, as well as the image information for the furniture. The presented three-dimensional space is represented, for example, by an omnidirectional image or a whole-sky sphere image.

In addition, the three-dimensional space presentation unit 136 transmits, together with the information on the three-dimensional space, furniture information on the arranged furniture, such as article information, shape information, color information, or price information for the furniture, to the user terminal 200 via the communication unit 110, and presents it to the user. This is because the user needs not only the appearance of furniture but also information such as a name, price, etc. when making a decision to purchase the furniture.

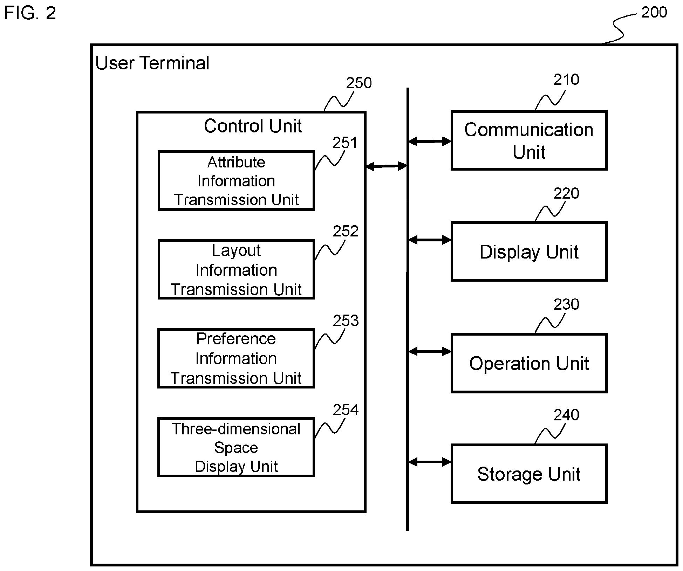

FIG. 2 is a functional configuration block diagram showing a user terminal 200 shown in FIG. 1. The user terminal 200 includes a communication unit 210, a display unit 220, an operation unit 230, a storage unit 240, and a control unit 250.

The communication unit 210 is a communication interface for wired or wireless communication with the information providing apparatus 100 via the network NW, and may apply any communication protocol as long as they can mutually communicate. The communication protocol for the communication unit 210 to perform communication is, but is not limited to, for example TCP/IP.

The display unit 220 is a user interface for use in displaying an operation input by the user or data transmitted from the information providing apparatus 100, and includes a liquid crystal display or the like. The display unit 220 displays the attribute information, the room layout information, and the preference information that are input by the user, or the information on the three-dimensional space with the furniture arranged, which is transmitted from the information providing apparatus 100 to be presented.

The operation unit 230 is a user interface for a user to input operator guidance, and includes a keyboard, a mouse, a touch panel, or the like. With the operation unit 230, the user attribute information or the preference information is input.

The storage unit 240 stores a program, input data, or the like for executing various control processes or each function of the control unit 250, and includes, but is not limited to, for example a memory such as RAM and ROM, or a storage such as HDD, SSD, and flash memory. In addition, the storage unit 240 temporarily stores data communicated with the information providing apparatus 100.

By executing a program stored in the storage unit 240, the control unit 250 controls the overall operation of the user terminal 200, and includes, but is not limited to, an apparatus such as a CPU, an MPU, a GPU, a microprocessor, a processor core, a multiprocessor, an ASIC, an FPGA, and the like. As functions of the control unit 250, the control unit 250 includes an attribute information transmission unit 251, a layout information transmission unit 252, a preference information transmission unit 253, and a three-dimensional space display unit 254. The attribute information transmission unit 251, the layout information transmission unit 252, the preference information transmission unit 253, and the three-dimensional space display unit 254 are activated by a program stored in the storage unit 240 and executed by the user terminal 200.

The attribute information transmission unit 251 receives an input of the user attribute information from the operation unit 230 and transmits the input to the information providing apparatus 100 via the communication unit 210. The transmitted attribute information is received by the attribute information acquisition unit 131 of the information providing apparatus 100.

The layout information transmission unit 252 receives layout information for a room captured with a camera function through a user's operation and transmits the room layout information to the information providing apparatus 100 via the communication unit 210. The transmitted layout information is received by the layout information reception unit 132 of the information providing apparatus 100.

The preference information transmission unit 253 receives an input of the user's preference information from the operation unit 230 and transmits the input to the information providing apparatus 100 via the communication unit 210. The transmitted attribute information is received by the preference information acquisition unit 133 of the information providing apparatus 100.

The three-dimensional space display unit 254 receives, via the communication unit 210, the information on the three-dimensional space with the furniture arranged that is transmitted from the three-dimensional space presentation unit 136 of the information providing apparatus 100. The received information on the three-dimensional space is displayed on the display unit 220. Note that this three-dimensional space may be displayed on VR goggles or the like that are synchronized with the user terminal 200.

### <Process flow>

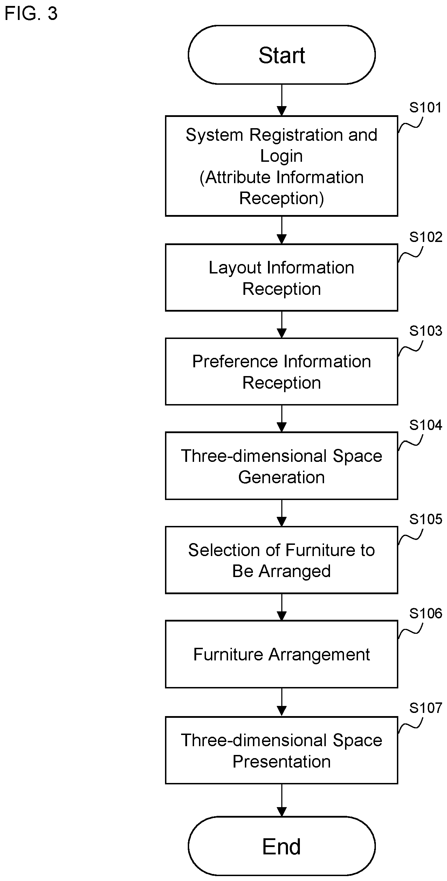

With reference to FIG. 3, an example flow of an information providing process executed by the information providing system 1 will be described. FIG. 3 is a flowchart showing an operation of the information providing system 1 shown in FIG. 1.

As processing of step S101, the information providing apparatus 100 performs user authentication in order to receive a service provided by the information providing system 1. For this reason, for example, information on the age, sex, and place of residence of the user is input with the user terminal 200 through a user's operation to perform user registration. At this time, the user attribute information is input into the attribute information transmission unit 251 of the user terminal 200, is received by the attribute information acquisition unit 131 of the information providing apparatus 100 via the communication unit 110, and is then held in the user DB 121. In addition, in order to log into the information providing system 1, a request is made to input account information and a password, and the user authentication is performed by checking whether the input information matches the registered information. If there is a match, logging into the information providing apparatus 100 is allowed.

As processing of step S102, the layout information transmission unit 252 of the user terminal 200 transmits the room layout information that is captured with a camera function through a user's operation to the information providing apparatus 100. The layout information reception unit 132 of the information providing apparatus 100 receives the layout information for the user's room via the communication unit 110.

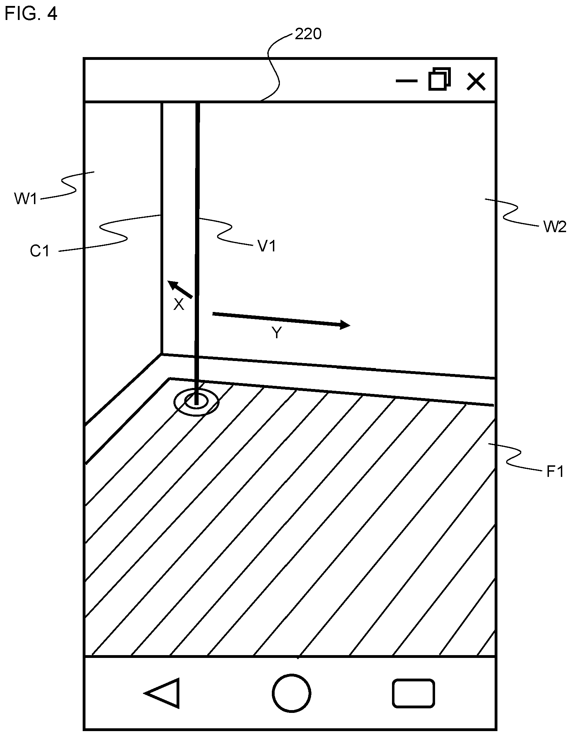

FIG. 4 is a schematic diagram showing an example of capturing layout information to be displayed on the display unit 220 shown in FIG. 2. When the layout information transmission unit 252 is activated by operating the user terminal 200, the camera function of the user terminal 200 is activated and enters a state for photographing or filming, and the user's room is photographed or filmed by a CCD camera or the like provided for the user terminal 200, and displayed on the display unit 220 as shown in FIG. 4.

As shown in FIG. 4, for example, the display unit 220 displays a user's room having a wall W1, a wall W2 vertically in contact with the wall W1, and a floor F1 horizontally in contact with the lower part of the walls W1 and W2. In addition, a reference line V1 for determining a position for starting to capture the layout information by the layout information transmission unit 252 is displayed vertically on the display unit 220. The reference line V1 is moved in the direction of an arrow X, and the user terminal 200 is moved to align with a predetermined position of the wall of the room, for example, a corner C1 provided between the wall W1 and the wall W2, and when the reference line V1 and the corner C1 overlap, capturing of the layout information is started.

Next, the reference line V1 is moved in the direction of an arrow Y, the user terminal 200 is made to go almost around the room along the wall of the room while photographing or filming to acquire image information for all directions toward the wall of the room. In a manner described above, the layout information for the user's room is acquired as an omnidirectional image or a whole-sky sphere image. The layout information is transmitted to the information providing apparatus 100.

As processing of step S103, the preference information acquisition unit 133 of the information providing apparatus 100 transmits a question about the user's preference information and the question is displayed on the display unit 220 of the user terminal 200. The preference information transmission unit 253 transmits the user's preference information that is input through a user's operation to the information providing apparatus 100. The preference information acquisition unit 133 of the information providing apparatus 100 receives the user's preference information via the communication unit 110.

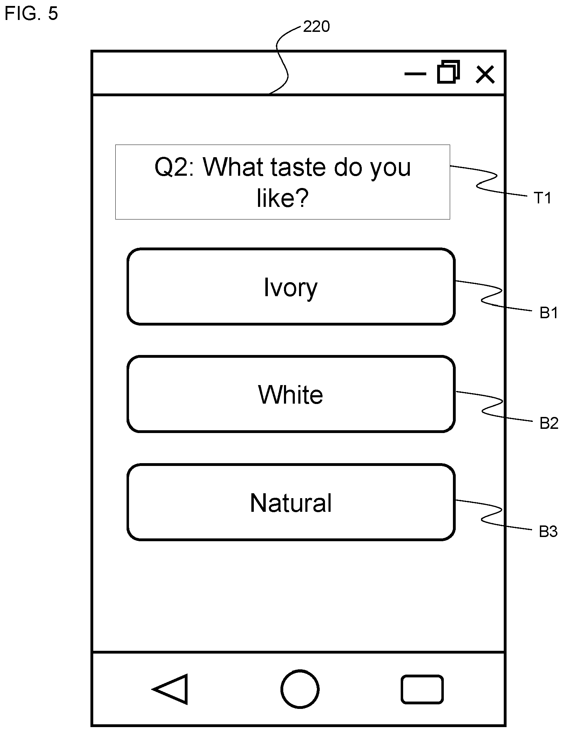

FIG. 5 is a schematic diagram showing an example of inputting preference information to be displayed on the display unit 220 shown in FIG. 2. When a question about the user's preference information is transmitted from the information providing apparatus 100, the content of the question and answer choices thereto are displayed on the display unit 220 of the user terminal 200, as shown in FIG. 5.

As shown in FIG. 5, for example, a question text T1 to select a taste for a living room or furniture of a house, which is a piece of the user's preference information, is displayed, and selection buttons B1, B2, and B3 are displayed on the display unit 220. The selection buttons B1, B2, and B3 are buttons respectively for answering "Ivory", "White", and "Natural" for the taste for the living room or furniture of the house. When the user selects (taps on the display unit 220) any one of the selection buttons B1, B2, and B3 in response to the question, the preference information transmission unit 253 receives and transmits the answer to the information providing apparatus 100.

As processing of step S104, the three-dimensional space generation unit 134 of the information providing apparatus 100 generates a three-dimensional space simulating the user's room based on the layout information for the user's room received in step S102. Information such as the layout of the user's room, dimensions of the interior of the room, a pattern on a floor or wall, a door or window, and the presence or absence of a storage space is extracted to generate the three-dimensional (3D)-modeled three-dimensional space simulating the user's room.

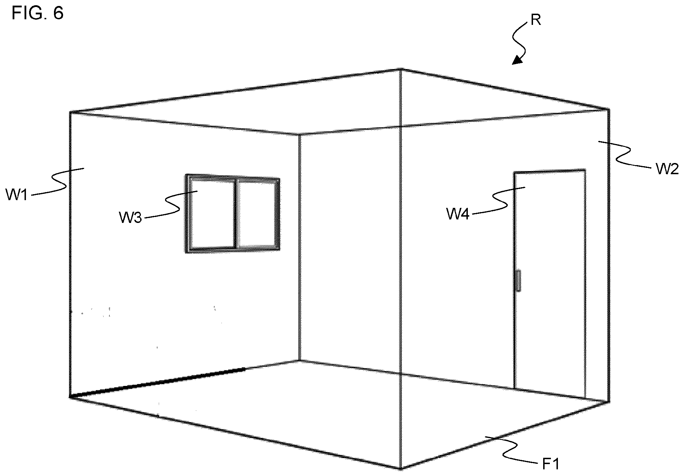

FIG. 6 is a schematic diagram showing an example three-dimensional space R generated by the three-dimensional space generation unit 134 shown in FIG. 1. In step S104, the layout of the user's room is calculated as information on a distance from the reference line V1 shown in FIG. 4, and a three-dimensional space R such as one having a wall W1, a wall W2, a window W3, and a door W4 is generated as shown in FIG. 6. At this time, information on a door or window, and the presence or absence of a storage space may also be included. Note that a decorative shape or pattern on the floor or the wall, though not shown in FIG. 6, may also be represented.

As processing of step S105, the furniture arrangement unit 135 selects furniture information pertaining to furniture suitable for the user from the furniture information held in the furniture DB 123, based on the attribute information received in step S101, the layout information received in step S102, or the preference information received in step S103.

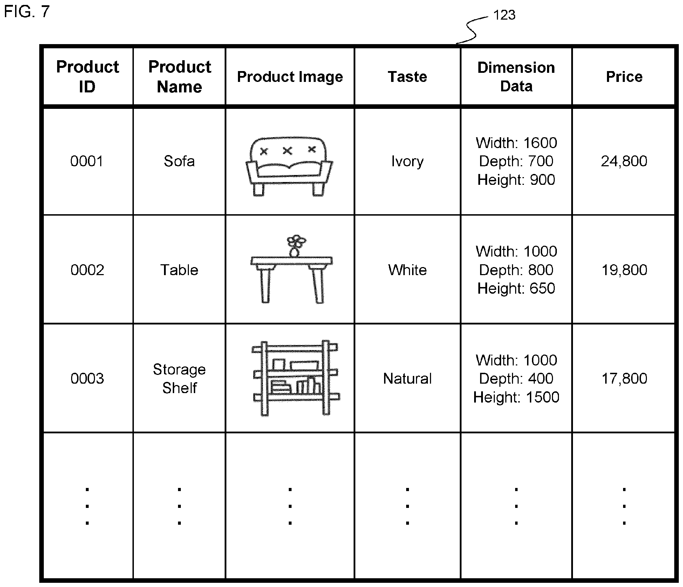

FIG. 7 is a schematic diagram showing example data held in the furniture DB 123 shown in FIG. 1. The furniture DB 123 contains information on a product name, a product image, a taste, dimension data, and a price, each of which corresponds to a column name in the furniture DB 123 shown in FIG. 7, in association with a product ID shown in FIG. 7.

The product ID is identification information for identifying the furniture information. The product name is an article name indicating a type of the furniture; for example, information such as "sofa", "table", and "storage shelf" is held. The product image is image information for the furniture for arranging the furniture in the three-dimensional space. The taste is information indicating the taste of the furniture; for example, information such as "Ivory", "White", and "Natural" is held. For the dimension data, the actual dimensions of the furniture is held as information on, for example, the width, depth, and height. The price is the price information for the furniture. In step S105, furniture information pertaining to furniture suitable for the user is selected based on these pieces of information.

As processing of step S106, the furniture arrangement unit 135 arranges the three-dimensional (3D)-modeled image information for the furniture selected in step S105 on the three-dimensional (3D)-modeled three-dimensional space generated in step S104.

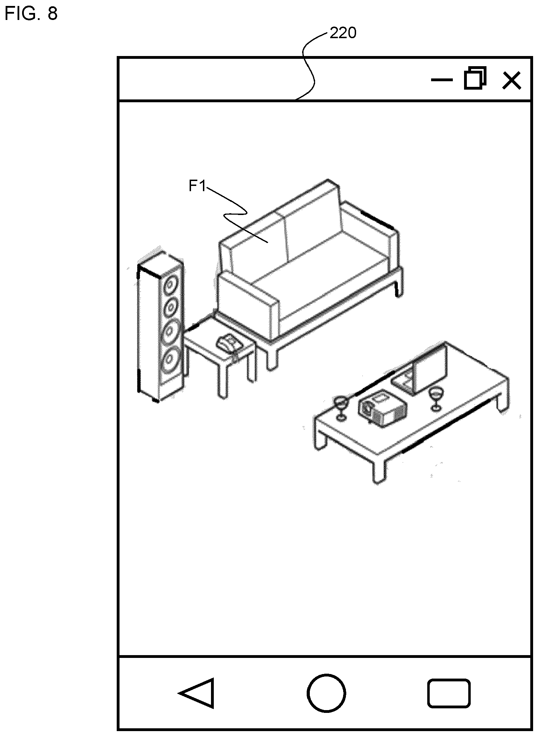

FIG. 8 is a schematic diagram showing an example of displaying a three-dimensional space to be displayed on the display unit 220 shown in FIG. 2. In step S106, the three-dimensional (3D)-modeled image information for the furniture, as in the product image shown in FIG. 7, that is selected in step S105 is arranged on the three-dimensional space shown in FIG. 6. In the example shown in FIG. 8, a sofa set F1 is arranged as example furniture. In step S107 described below, the resultant information is transmitted to the user terminal 200 and displayed on the display unit 220.

As processing of step S107, the three-dimensional space presentation unit 136 transmits the three-dimensional space with the furniture arranged to the user terminal 200 via the communication unit 110. The three-dimensional space display unit 254 of the user terminal 200 displays the received information on the three-dimensional space on the display unit 220 as shown in FIG. 8. At this time, since the three-dimensional space presentation unit 136 also transmits the furniture information for the arranged furniture, the three-dimensional space display unit 254 also displays the furniture information received.

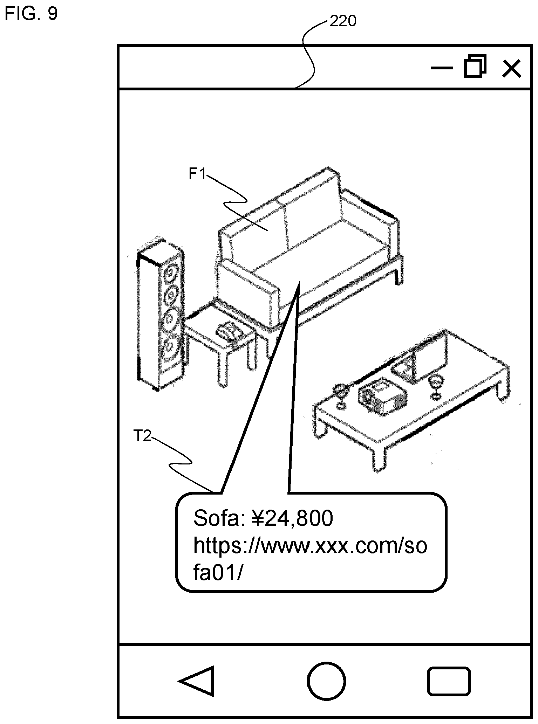

FIG. 9 is a schematic diagram showing an example presentation of furniture information displayed on the display unit 220 shown in FIG. 2. As shown in FIG. 9, the furniture information received in step S107 is displayed on the display of the three-dimensional space shown in FIG. 8 as furniture information T2 as shown in FIG. 9. For the furniture information T2, for example, a product name (an article name of the furniture), a price, and information on a link to a web page for referring to the furniture are displayed. The user can decide whether to purchase the furniture by referring to this furniture information as well.

### <Advantageous Effect>

As described above, in the information providing apparatus, the information providing system, and the information providing method according to the present embodiment, the layout information reception unit receives the layout information for the user's room, the three-dimensional space generation unit generates the three-dimensional space based on the layout information, the furniture arrangement unit selects the furniture information suitable for the user, and the three-dimensional space with this furniture arranged is presented to the user. Accordingly, it is possible to present the state in which furniture pertaining to the furniture information is arranged in the layout information of an actual residence received from the user. It is thus possible for the user to visually grasp an image of candidate furniture for purchase arranged in the actual residence through the three-dimensional space.

In addition, an attribute information reception unit receives the user attribute information, a preference information reception unit receives the preference information indicating a user's preference for a room, and the furniture arrangement unit selects the furniture information suitable for the user based on the user attribute information and the preference information. This makes it possible to present furniture that is close to the user's preference.

### (Embodiment 2)

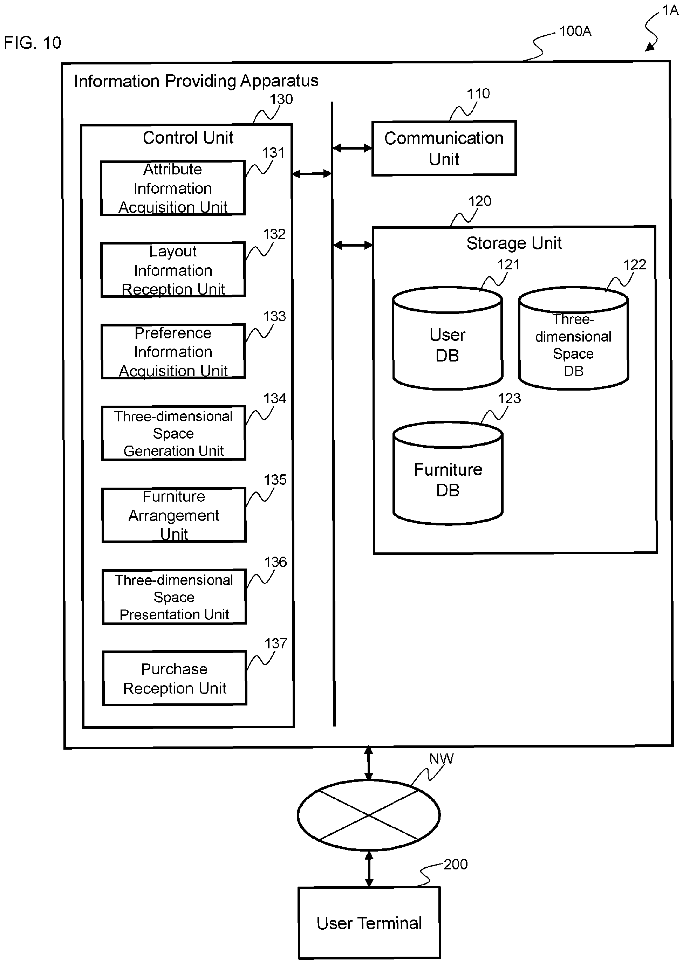

FIG. 10 is a functional configuration block diagram showing an information providing system 1A according to Embodiment 2 of the present disclosure. The information providing system 1A is similar to the information providing system 1 according to Embodiment 1 in that it is a system operated by a vendor who sells furniture which provides information on furniture that is merchandise and which presents furniture for sale that is arranged in a three-dimensional space based on layout information for a room of a user who is a customer of the vendor; however, the information providing system 1A differs from the information providing system 1 according to Embodiment 1 in that the information providing system 1A includes a purchase reception unit 137 as a function of the control unit 130. The rest of the configuration and process flow are the same as in Embodiment 1.

Embodiment 2 includes means for actually purchasing the furniture presented in Embodiment 1.

The purchase reception unit 137 receives, from the user terminal 200, an input reporting that the user will actually purchase the furniture which is arranged in the three-dimensional space by the furniture arrangement unit 135 and is presented by the three-dimensional space presentation unit 136.

For example, when the furniture information T2 shown in FIG. 9 is selected (tapped on the display unit 220), the purchase reception unit 137 is activated and the display unit 220 displays a screen for proceeding with the purchase (not shown). The user inputs the manner of payment, etc. by operating the user terminal 200 to express the intention to make the payment, whereby the furniture is actually sold.

According to Embodiment 2, in addition to the advantageous effect due to Embodiment 1 above, the purchase reception unit allows the user to proceed with purchase of the furniture. This facilitates the procedure for purchasing the furniture, and thus can prevent a furniture dealer from losing an opportunity to acquire customers owing to a troublesome purchasing procedure.

### (Embodiment 3)

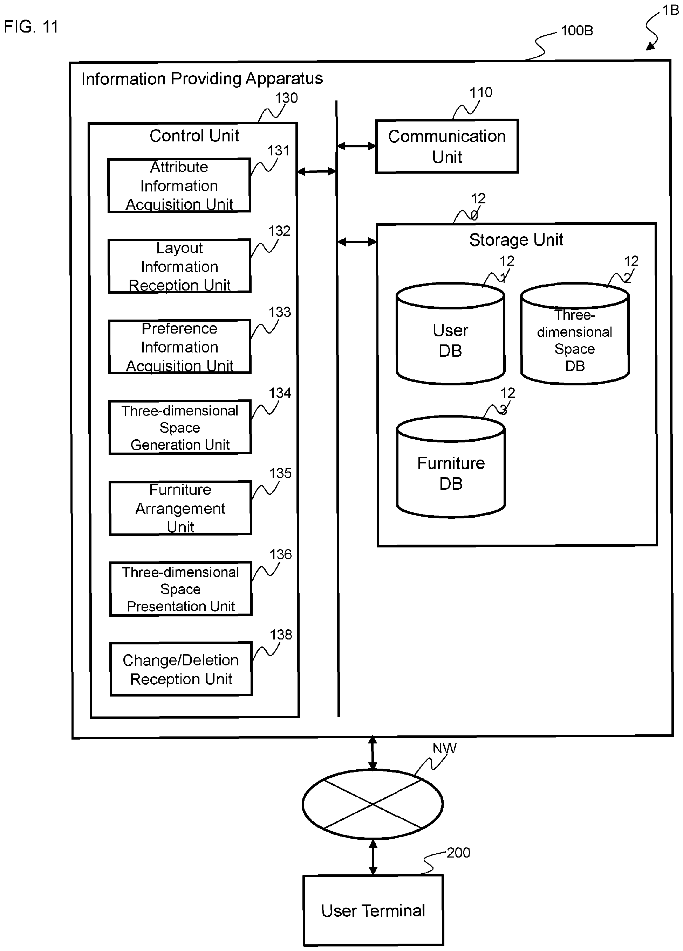

FIG. 11 is a functional configuration block diagram showing an information providing system 1B according to Embodiment 3 of the present disclosure. The information providing system 1B is similar to the information providing system 1 according to Embodiment 1 in that it is a system operated by a vendor who sells furniture which provides information on furniture that is merchandise and which presents furniture for sale that is arranged in a three-dimensional space based on layout information for a room of a user who is a customer of the vendor; however, the information providing system 1B differs from the information providing system 1 according to Embodiment 1 in that the information providing system 1B includes a change/deletion reception unit 138 as a function of the control unit 130. The rest of the configuration and process flow are the same as in Embodiment 1.

Embodiment 3 includes a function for moving the position of, changing, or deleting the furniture presented in Embodiment 1.

The change/deletion reception unit 138 receives, from the user terminal 200, an input reporting that the furniture which is arranged in the three-dimensional space by the furniture arrangement unit 135 and is presented by the three-dimensional space presentation unit 136 will be moved to another position in this three-dimensional space, changed to other furniture, or deleted.

For example, when a predetermined operation (e.g., selecting furniture of interest and swiping it to another position) is performed on the display unit 220 in order to move the sofa set F1 shown in FIG. 9 to another position in the three-dimensional space, the sofa set F1 is displayed at the other position after the movement. Also, for example, when a predetermined operation (e.g., selecting the furniture of interest and swiping it off the screen) is performed on the display unit 220 in order to change the sofa set F1 shown in FIG. 9 to another piece of furniture or delete it, the other piece of furniture is selected again from the furniture DB 123 or the furniture is deleted from the three-dimensional space displayed on the display unit 220.

According to Embodiment 3, in addition to the advantageous effect due to Embodiment 1 above, the change/deletion reception unit changes or deletes the presented furniture. This allows the furniture selected by the furniture arrangement unit, when it does not meet the preference, to be changed or deleted, which enables presentation of furniture that is closer to the user's preference.

### (Embodiment 4 (program))

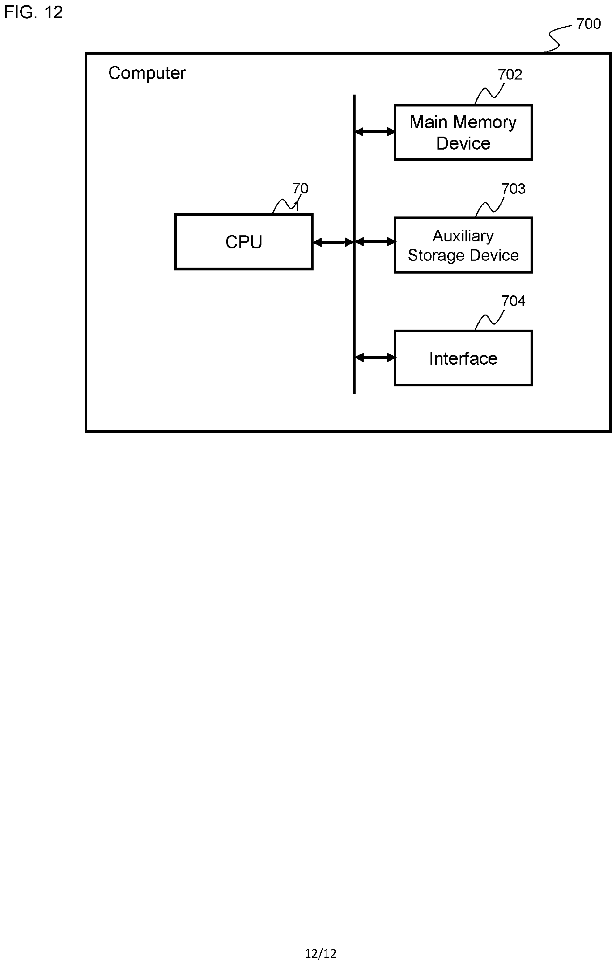

FIG. 12 is a functional configuration block diagram showing an example configuration of a computer (electronic computer) 700. The computer 700 includes a CPU 701, a main memory device 702, an auxiliary storage device 703, and an interface 704.

Here, described below are details of a control program (information providing program) for fulfilling each of the functions constituting the attribute information acquisition unit 131, the layout information reception unit 132, the preference information acquisition unit 133, the three-dimensional space generation unit 134, the furniture arrangement unit 135, the three-dimensional space presentation unit 136, the purchase reception unit 137, and the change/deletion reception unit 138 according to Embodiments 1 to 3. These function blocks are implemented in the computer 700. An operation of each of these components is stored in the auxiliary storage device 703 in the form of a program. The CPU 701 reads a program from the auxiliary storage device 703, expands it to the main memory device 702, and executes the aforementioned process according to the program. In addition, the CPU 701 secures a storage area corresponding to the above-described storage unit in the main memory device 702 according to the program.

The program is more specifically a control program for causing the computer 700 to fulfill: a user information acquisition step of acquiring information on a user; a layout information reception step of receiving an input of layout information for room from a user; a three-dimensional space generation step of generating a 3D-modeled three-dimensional space based on the received layout information; a furniture arrangement step of selecting furniture information suitable for the user from furniture information stored in advance, based on the user information and the layout information, and arranging furniture pertaining to the selected furniture information in the three-dimensional space; and a three-dimensional space presentation step of presenting the three-dimensional space with the furniture arranged to the user.

Note that the auxiliary storage device 703 is an example of a non-transitory tangible medium. Other examples of the non-transitory tangible medium include a magnetic disk, an optical magnetic disk, a CD-ROM, a DVD-ROM, and a semiconductor memory that are connected via the interface 704. When the program is delivered to the computer 700 via a network, the computer 700 upon receipt of the delivery may expand the program to the main memory device 702 to execute the aforementioned process.

In addition, the program may be a program for fulfilling a part of the aforementioned functions. Further, the program may be a so-called difference file (difference program), which is a program that fulfills the aforementioned functions in combination with another program already stored in the auxiliary storage device 703.

While embodiments according to the disclosure have been described above, these embodiments can be implemented in various other forms, with various omissions, substitutions, and changes. These embodiments and modifications, and those with omissions, substitutions, and changes are included in the technical scope of the claims and the equivalent scope thereof.

### REFERENCE SIGNS LIST

1, 1A, 1B: an information providing system, 100, 100A, 100B: an information providing apparatus, 110: a communication unit, 120: a storage unit, 121: a user DB, 122: a three-dimensional space DB, 123: a furniture DB, 130: a control unit, 131: an attribute information reception unit, 132: a layout information reception unit, 133: a preference information reception unit, 134: a three-dimensional space generation unit, 135: a furniture arrangement unit, 136: a three-dimensional space presentation unit, 137: a purchase reception unit, 138: a change/deletion reception unit, 200: a user terminal, 210: a communication unit, 220: a display unit, 230: an operation unit, 240: a storage unit, 250: a control unit, 251: an attribute information transmission unit, 252: a layout information transmission unit, 253: a preference information transmission unit, 254: a three-dimensional space display unit, NW: a network

## Claims

1. An information providing apparatus comprising:
a user information acquisition unit that acquires information on a user;
a layout information reception unit that receives an input of layout information for a room from the user;
a three-dimensional space generation unit that generates a 3D-modeled three-dimensional space based on the received layout information;
a furniture arrangement unit that selects, from furniture information stored in advance, furniture information suitable for the user based on the user information and the layout information and arranges furniture pertaining to the selected furniture information in the three-dimensional space; and
a three-dimensional space presentation unit that presents the three-dimensional space with the furniture arranged to the user.

2. The information providing apparatus according to claim 1, wherein the furniture arrangement unit arranges the furniture pertaining to the furniture information that is selected from 3D-modeled furniture information stored in advance, in the three-dimensional space, and
the three-dimensional space presentation unit presents the 3D-modeled three-dimensional space with the furniture arranged to the user.

3. The information providing apparatus according to claim 2, wherein the three-dimensional space presentation unit presents the user with the furniture information in the three-dimensional space with the furniture arranged.

4. The information providing apparatus according to any one of claims 1 to 3, wherein the information providing apparatus comprises a change/deletion reception unit that moves the arranged furniture to another position in the three-dimensional space, changes the arranged furniture to other furniture, or deletes the arranged furniture, in the three-dimensional space with the furniture arranged.

5. The information providing apparatus according to any one of claims 1 to 4, wherein the user information acquisition unit acquires attribute information for the user, and preference information indicating a preference of the user for a room.

6. The information providing apparatus according to claim 5, wherein the furniture arrangement unit selects furniture information suitable for the user from purchase information on a furniture purchasing history of another user having attribute information similar to the attribute information.

7. The information providing apparatus according to claim 5 or 6, wherein the furniture arrangement unit determines preference information of the user based on an answer to one or more questions to the user and selects furniture information suitable for the user from the determined preference information.

8. The information providing apparatus according to any one of claims 1 to 7, wherein the information providing apparatus comprises a purchase reception unit that receives, from the user, an input of purchasing of the furniture in the three-dimensional space with the furniture arranged.

9. The information providing apparatus according to any one of claims 1 to 8, wherein the furniture arrangement unit determines atmosphere information indicating an atmosphere of the room based on the layout information and selects furniture information suitable for the user from the determined atmosphere information.

10. The information providing apparatus according to any one of claims 1 to 9, wherein the furniture arrangement unit selects furniture information suitable for the user based on any one or more of article information, shape information, color information, or price information for furniture that are stored as the furniture information.

11. The information providing apparatus according to any one of claims 1 to 10, wherein the layout information reception unit receives image information or video information captured by a user photographing or filming the room, as the layout information.

12. The information providing apparatus according to claim 11, wherein the layout information reception unit receives the layout information based on a coordinate displacement from a feature point that is a predetermined position in a horizontal direction of the room.

13. The information providing apparatus according to any one of claims 1 to 12, wherein the three-dimensional space generation unit determines a dimension of the three-dimensional space based on the received layout information, and
the furniture arrangement unit arranges the furniture pertaining to the selected furniture information in the three-dimensional space based on the dimension.

14. The information providing apparatus according to any one of claims 1 to 13, wherein the three-dimensional space generation unit performs a coordinate transformation to project the three-dimensional space onto a two-dimensional plane.

15. The information providing apparatus according to any one of claims 1 to 14, wherein the three-dimensional space presentation unit presents the user with the three-dimensional space with the furniture arranged through an omnidirectional image or a whole-sky sphere image.

16. The information providing apparatus according to any one of claims 1 to 14, wherein the three-dimensional space presentation unit presents the user with the three-dimensional space with the furniture arranged, the three-dimensional space being displayed on VR goggles.

17. An information providing system comprising an information providing apparatus and a user terminal,
the information providing apparatus including:
a user information acquisition unit that acquires information on a user;
a layout information reception unit that receives layout information for a room from the user terminal;
a three-dimensional space generation unit that generates a 3D-modeled three-dimensional space based on the received layout information;
a furniture arrangement unit that selects, from furniture information stored in advance, furniture information suitable for the user based on the user information and the layout information and arranges furniture pertaining to the selected furniture information in the three-dimensional space; and
a three-dimensional space presentation unit that transmits the three-dimensional space with the furniture arranged to the user terminal, and
the user terminal including:
a layout information transmission unit that receives an input of layout information for room from the user to transmit the input to the information providing apparatus; and
a three-dimensional space display unit that receives the three-dimensional space with the furniture arranged from the information providing apparatus and displays the received three-dimensional space for the user.

18. An information providing method comprising:
a user information acquisition step of a user information acquisition unit acquiring information on a user;
a layout information reception step of a layout information reception unit receiving layout information for a room from the user;
a three-dimensional space generation step of a three-dimensional space generation unit generating a 3D-modeled three-dimensional space based on the received layout information;
a furniture arrangement step of a furniture arrangement unit selecting, from furniture information stored in advance, furniture information suitable for the user based on the user information and the layout information, and arranging furniture pertaining to the selected furniture information in the three-dimensional space; and
a three-dimensional space presentation step of a three-dimensional space presentation unit presenting the user with the three-dimensional space with the furniture arranged.

19. An information providing program for causing an electronic computer to execute:
a user information acquisition step of acquiring information on a user;
a layout information reception step of receiving an input of layout information for a room from the user;
a three-dimensional space generation step of generating a 3D-modeled three-dimensional space based on the received layout information;
a furniture arrangement step of selecting, from furniture information stored in advance, furniture information suitable for the user based on the user information and the layout information, and arranging furniture pertaining to the selected furniture information in the three-dimensional space; and
a three-dimensional space presentation step of presenting the user with the three-dimensional space with the furniture arranged.
